# EUROPEAN PATENT APPLICATION

(11) **EP 2 469 556 A1**
(43) Date of publication of application: **27.06.2012**
(21) Application number: 11192706.7
(22) Date of filing: 09.12.2011
(51) Int. Cl.: H01H 13/705, H03K 17/96

(54) **Dome switch with touch detection function**

(30) Priority: 21.12.2010 CN 201010612186; 07.12.2011 US 201113313048
(71) Applicant: Sony Ericsson Mobile Communications AB, 221 88 Lund (SE)
(72) Inventor: Liu, Yinong, Beijing Beijing 100102 (CN); Li, XueQiang, Beijing Beijing 100102 (CN)
(74) Representative: Aurell, Henrik

(57) **Abstract**

A key for electronic apparatus, e.g., a mobile phone, the key combines touch detection function with mechanical key pressing function. The key includes a dome (415), contact points member (420), e.g., a gold key finger, on a circuit board of the electronic apparatus and below the dome; a plurality of SMT pads (411-414) on the circuit board about the contact points member, the dome connected to at least two (413,414) of the SMT pads, and the contact points member connected to a third (411) of the SMT pads, and wherein the dome is connected to a capacitive touch detection scan circuit (430) and the capacitive touch detection scan circuit is configured to detect a capacitance change caused by a finger's touch on the key.

## Description

### Technical Field

The present invention relates to keys of an electronic device, and more particularly, to keys with a touch detection function and an electronic apparatus with the keys.

### Description of the Related Art

Currently, various electronic apparatuses, such as telephone, computer, personal computer (PC), notebook computer, personal digital assistant (PDA), mobile phone (cell phone) or other portable electronic apparatuses, need to be used in people's daily lives and works. These electronic apparatuses usually have an input device so that the user can input expected information or instruction to the electronic apparatus. For example, a keypad is a most frequently used input device.

A portable electronic apparatus such as the mobile phone has a small size as compared with the computer, the PC, the notebook computer, etc., thus the keys on the keypad are relatively less. Typically, the key circuit of the mobile phone includes contact points and contact sheets. The contact points are usually made of copper foil on the circuit board of the mobile phone. Since the contact points are conventionally gold plated, they are also called key gold fingers, each of which usually consists of two independent contact points, and these key gold fingers form a key panel matrix. The contact sheets are usually made of conductive rubber or dome switches. For the convenience of usage, each contact sheet is correspondingly provided with a touch key, and during usage, the main control chip on the main circuit board of the mobile phone scans the key matrix to obtain identification information indicating that the key is pressed. The keypad has a set of contact points which do not ordinarily contact the contact sheets. When a certain touch key is pressed, the contact sheet contacting such touch key contacts the corresponding set of contact points simultaneously, so that the line connecting two contact points is closed. All the contact points form a keypad matrix, and the keypad circuit (except the touch screen) of the mobile phone usually confirms and identifies a key by dynamically scanning the keypad matrix.

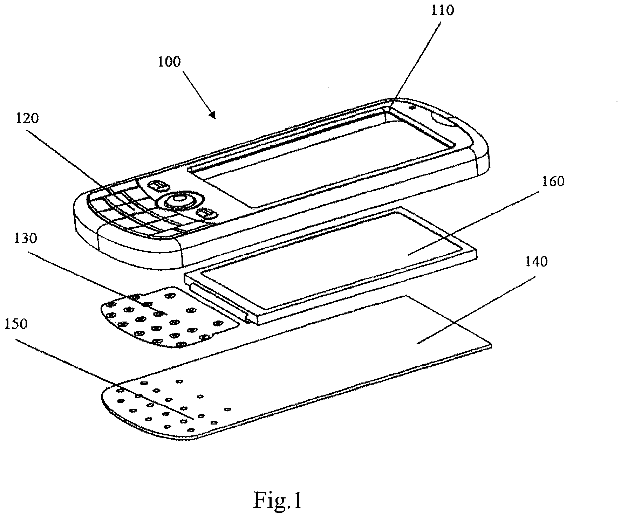

Fig. 1 illustrates an exploded stereo view of a typical straight mobile phone. The mobile phone 100 includes a housing frame 110, keys 120 provided on the housing frame 110, dome switches 130 provided below the keys 120 and corresponding thereto, a main circuit board 140, a key gold finger matrix 150 provided on the main circuit board 140 and corresponding to the dome switches 130, and a display screen 160 provided between the housing frame 110 and the main circuit board 140 and in parallel with the dome switches 130.

The mobile phones in other forms, such as clamshell mobile phone and sliding mobile phone, are substantially similar to the straight mobile phone as illustrated in Fig. 1, and the major difference is that the phone body is divided into two parts which are movable relative to each other.

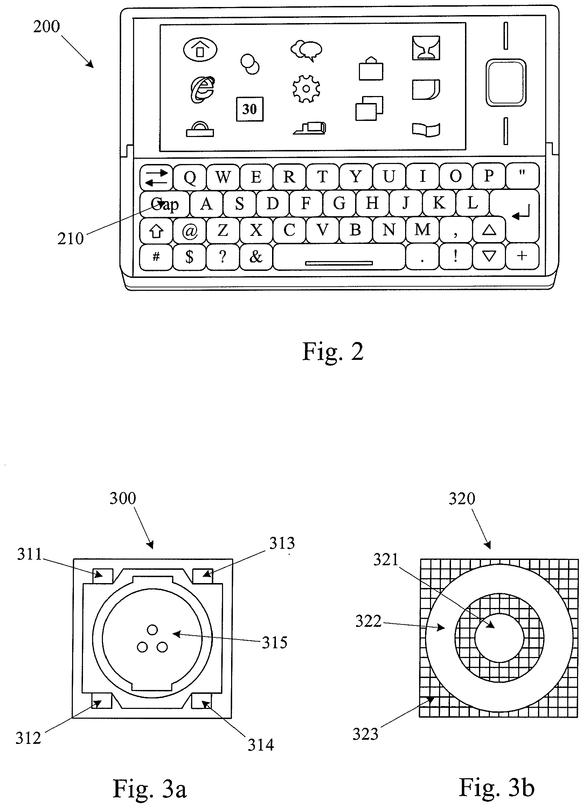

As illustrated in Fig. 1, a common mobile phone has a 4×5 or 5×5 key matrix. Since the number of the keys is limited, several symbols and/or functions are usually overlapped on the same key, which causes inconveniences to operations. Fig. 2 illustrates a foldable mobile phone 200 with a QWERTY keypad 210. As compared with the conventional mobile phone with a 4×5 or 5×5 key matrix, the mobile phone 200 with the QWERTY keypad 210 has more keys, thus the symbols and/or functions distributed to each key are reduced, and the operations may be more convenient.

On the other hand, at present, many electronic apparatuses, especially the portable electronic apparatuses, are provided with a function of touch panel or touch screen. The user can change the position of the cursor in the display screen just by slightly sliding his finger on the touch panel or the touch screen, so as to perform corresponding operation. This greatly facilitates the user's operation and improves the user's experience.

However, the current electronic apparatuses, such as the mobile phones, just have one of the keypad function and the above function of touch panel or touch screen, or although they have the two functions simultaneously, the two functions are implemented independently by hardware separated from each other. On one hand, this causes inconveniences to the users, and on the other hand, it is adverse to compact the appearance of the electronic apparatus so as to meet the demand of portable carriage. For example, whether in the mobile phone 100 as illustrated in Fig. 1, or the mobile phone 200 as illustrated in Fig. 2, the current keypad design does not combine the key function with the touch detection function and also the current keypad design makes it impossible to combine the key function with the touch detection function.

### Summary of the Invention

Therefore, the electronic apparatuses, particularly portable electronic apparatuses such as mobile phones, require a touch key scheme that combines the key function with the touch detection function, so as to facilitate the usage of the electronic apparatuses.

The present invention is proposed with respect to the above problems of the prior art. The present invention provides keys with a touch detection function and an electronic apparatus including the keys, wherein the keys combine the touch detection function with the mechanical key pressing function, thus greatly promoting the usage convenience for the users, and contribute to designing the electronic apparatus more compactly.

According to a first aspect of the present invention, a key with touch detection function for an electronic apparatus is provided, including: a dome; a key gold finger provided on a circuit board of the electronic apparatus and below the dome; a plurality of SMT pads provided on the circuit board of the electronic apparatus and around the key gold finger; wherein the dome is connected to at least two of the plurality of SMT pads, and the key gold finger is connected to one of the plurality of SMT pads, and wherein, the dome is connected to a capacitive touch detection scan circuit provided on the circuit board of the electronic apparatus, the capacitive touch detection scan circuit is configured to detect a capacitance change caused by a finger's touch on the key, so as to form a signal indicating touch position and/or movement of the finger by combining a position of the key.

According to a second aspect of the present invention, the key with touch detection function for an electronic apparatus of the first aspect is provided, wherein the dome is connected to the capacitive touch detection scan circuit through a blocking capacitor. Thus, the influence by the key pressing operation on the touch detection can be avoided.

According to a third aspect of the present invention, the key with touch detection function for an electronic apparatus of the second aspect is provided, wherein the blocking capacitor has a capacitance of 1 pF.

According to a fourth aspect of the present invention, the key with touch detection function for an electronic apparatus of the first aspect is provided, wherein there are a plurality of domes, and the number of the key gold fingers is the same as that of the domes, thereby a keypad matrix having a plurality of keys is formed.

According to a fifth aspect of the present invention, the key with touch detection function for an electronic apparatus of the first aspect is provided, wherein the key gold finger is formed by a single metal material portion.

According to a sixth aspect of the present invention, an electronic apparatus is provided, including: keys with touch detection function, a circuit board, and a capacitive touch detection scan circuit, the key with touch detection function includes: a dome; a key gold finger provided on the circuit board and below the dome; a plurality of SMT pads provided on the circuit board and around the key gold finger; wherein the dome is connected to at least two of the plurality of SMT pads, and the key gold finger is connected to one of the plurality of SMT pads, wherein the dome is connected to the capacitive touch detection scan circuit, and the capacitive touch detection scan circuit is configured to detect a capacitance change caused by a finger's touch on the key, so as to form a signal indicating touch position and/or movement of the finger by combining a position of the key.

According to a seventh aspect of the present invention, the electronic apparatus of the sixth aspect is provided, wherein the dome is connected to the capacitive touch detection scan circuit through a blocking capacitor.

According to an eighth aspect of the present invention, the electronic apparatus of the seventh aspect is provided, wherein the blocking capacitor has a capacitance of 1 pF.

According to a ninth aspect of the present invention, the electronic apparatus of the sixth aspect is provided, wherein the function of the capacitive touch detection scan circuit is enabled and/or disabled through software setting or button operation.

According to a tenth aspect of the present invention, the electronic apparatus of the sixth aspect is provided, wherein there are a plurality of domes, and the number of the key gold fingers is the same as that of the domes, thereby a keypad matrix having a plurality of keys is formed.

According to an eleventh aspect of the present invention, the electronic apparatus of the sixth aspect is provided, wherein the key gold finger is formed by a single metal material portion.

According to a twelfth aspect of the present invention, the electronic apparatus of the sixth aspect is provided, wherein the capacitive touch detection scan circuit is configured to determine whether the key is touched by the finger by comparing the detected key capacitance with a predetermined threshold.

According to a thirteenth aspect of the present invention, the electronic apparatus of the twelfth aspect is provided, wherein the predetermined threshold is set based on a capacitance when the key is not touched by the finger.

According to a fourteenth aspect of the present invention, the electronic apparatus of the sixth aspect is provided, wherein the electronic apparatus is a portable electronic apparatus.

The keys with touch detection function and the electronic apparatus including the keys according to the present invention can detect both a key pressing operation when the key is pressed and a capacitance change caused when the finger touches the key, and can form a signal indicating position of a cursor on the display screen of the electronic apparatus by using the capacitance change and combining a position of the key. Thus the space of the electronic apparatus is saved, and the user's operation is convenient, which greatly improves the usage convenience.

These and further aspects and features of the present invention will be apparent with reference to the following description and attached drawings. In the description and drawings, particular embodiments of the invention have been disclosed in detail as being indicative of some of the ways in which the principles of the invention may be employed, but it is understood that the invention is not limited correspondingly in scope. Rather, the invention includes all changes, modifications and equivalents coming within the spirit and terms of the appended claims.

Features described and/or illustrated with respect to one embodiment can be used in one or more other embodiments in a same or similar way, and/or combine with or replace features in other embodiments.

To be noted, the term "include/comprise/have" herein refers to existence of feature, component, step and assembly, not excluding existence or addition of one or more other features, components, steps, assemblies or a combination thereof.

Many aspects of the present invention can be understood better with reference to the following drawings. The constituent parts of the drawings are not necessarily drafted in proportion or to scale, but are presented just for illustrating the present invention more clearly. For the convenience of illustrating and describing some parts of the present invention, and promoting the understanding of the embodiments, some parts of the drawings may be enlarged, e.g., enlarging those parts with respect to other parts in an exemplary apparatus practically manufactured according to the present invention. Elements and features described in a drawing or embodiment of the present invention can be combined with elements and features illustrated in one or more other drawings or embodiments. In addition, same or corresponding reference signs are used to represent same or corresponding constituent parts in all the drawings, and they also can be used to represent same or corresponding constituent parts in more than one of the embodiments.

### Brief Description of the Drawings

The accompanying drawings constitute a part of the specification, illustrate the embodiments of the present invention and together with the description serve to explain the principle of the present invention. Obviously, the drawings described as follows are just some embodiments of the present invention, and a person skilled in the art can obtain other drawings based on these drawings without paying any creative effort.

In the drawings:
Fig. 1 illustrates an exploded stereo view of a straight mobile phone of the prior art, and the mobile phone includes key switches composed of domes and key gold fingers;
Fig. 2 illustrates a stereo view of a foldable mobile phone with a QWERTY keypad of the prior art;
Fig. 3 illustrates a conventional surface mounted technology (SMT) demo key switch (also referred to as exemplary or representative key switch), wherein (a) is an external structure view of the conventional SMT demo (or exemplary or representative) key switch, and (b) is a structure view of a key gold finger in the conventional SMT demo key switch;
Fig. 4 illustrates a schematic plan view of a structure of an SMT demo key according to an embodiment of the present invention;
Fig. 5 illustrates a schematic side view of a structure of an SMT demo key according to an embodiment of the present invention; and
Fig. 6 illustrates a schematic circuit connection view of an SMT demo key according to an embodiment of the present invention.

### Detailed Description of the Preferred Embodiments

The interchangeable terms "electronic apparatus" and "electronic device" include portable radio communication apparatus. The term "portable radio communication apparatus", which hereinafter is referred to as a "mobile radio terminal", "portable electronic device", or "portable communication device", comprises all apparatuses such as mobile telephones, pagers, communicators, electronic organizers, personal digital assistants (PDAs), smartphones, portable communication devices or the like.

In the present application, embodiments of the invention are described primarily in the context of a portable electronic device in the form of a mobile telephone (also referred to as "cell phone"). However, it shall be appreciated that the invention is not limited to the context of a mobile telephone and may relate to any type of appropriate electronic apparatus. Examples of such electronic apparatus include media player, game machine, PDA, computer, digital camera and the like.

The preferred embodiments of the present invention are described as follows with reference to the drawings.

The SMT dome key is an SMT mechanical key, which combines the dome, the key gold finger, and the SMT pad. Such key is widely used in the design of mobile phones as for example power key, camera key, side key, volume key and navigation key.

The structure of the conventional SMT dome key is described as follows with reference to Fig. 3.

Fig. 3 (a) illustrates an external structure view of an SMT demo key 300. The four corners are provided with SMT pads 311, 312, 313, 314 respectively, and the center is provided with a spherical crown-shaped dome 315. The dome 315 has an appropriate elasticity for the convenience of finger pressing and recovering to the original state after releasing the press.

Fig. 3 (b) illustrates a structure view of a key gold finger 320 included in the SMT demo key 300. The typical structure of the key gold finger 320 includes a KEY_IN 321 and a KEY_OUT 322. It is known by a person skilled in the art that KEY_IN and KEY_OUT are connection terminals of a keypad scan circuit, respectively, thus the details are not described herein. That is, the KEY_IN 321 and the KEY_OUT 322 of the key gold finger 320 are electrically connected to the KEY_IN terminal and the KEY_OUT terminal of the keypad scan circuit, respectively.

The KEY_IN 321 and the KEY_OUT 322, for example, are formed by plating metal material (e.g., copper) having an excellent conductivity on an insulation substrate 323. Preferably, the KEY_IN 321 and the KEY_OUT 322 may be plated with gold to increase the conductivity when they are contacting with the dome 315. In addition, preferably, the KEY_IN 321 may be provided with one or more bumps to improve the contact degree between the dome 315 and the KEY_IN 321 when the key is pressed.

The KEY_IN 321 of the key gold finger 320 is electrically connected to the SMT pads 311, 312 through wiring (not shown), and the KEY_OUT 322 is electrically connected to the SMT pads 313, 314 through wiring (not shown). The SMT pads 311, 312, 313, 314 are electrically connected to corresponding terminals of the keypad scan circuit.

The work principle of the SMT demo key 300 is briefly introduced as follows.

Firstly, the KEY_IN 321 and the KEY_OUT 322 of the key gold finger 320 are both pulled up to a high level. When the key scanning is performed, a key scan circuit (not shown) firstly pulls down the KEY_OUT 322 to the ground, and then detects the level state of the KEY_IN 321.

If the key 300 is not pressed, the KEY_IN 321 still keeps the high level; while if the key 300 is pressed, the dome 315 electrically connects the KEY_IN 321 to the KEY_OUT 322, so as to electrically connect the KEY_IN 321 to the ground, then the KEY_IN 321 also becomes low level (ground level). Thus, the press/release of the key 300 can be detected by detecting the level change of the KEY_IN 321.

Thus, when the key 300 is pressed by the finger, the keypad scan circuit can detect corresponding key pressing operation by contacting the dome 315 with the KEY_IN 321 and the KEY_OUT 322 of the key gold finger 320, respectively.

When the SMT dome key 300 described above is not pressed, the dome 315 and the key gold finger 320 substantively form a capacitor. When the finger touches the dome 315, an inductive capacitance of the human body will overlap the capacitance between the dome 315 and the key gold finger 320, which causes a capacitance change. Thus a touch by the finger to the SMT dome key 300 can be detected by detecting such capacitance change.

When the finger slides on a keypad including a plurality of such keys 300 while touching the keys, the sliding of the finger on the whole keypad can be detected by combining the detection of the capacitance change and the position of each key, so as to form a signal indicating position and/or movement of the finger. The position of a cursor on the display screen of the electronic apparatus can be moved by using the signal.

On this basis, the SMT dome keys with touch detection function of the present invention are proposed.

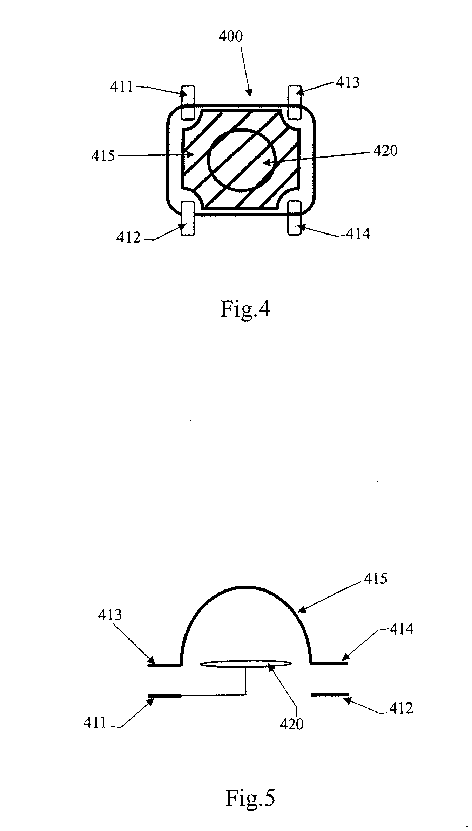

The SMT dome keys with touch detection function according to the embodiments of the present invention are described as follows with reference to Figs. 4-6.

For the sake of convenience, only one key is described as an example. But in fact, the electronic apparatus may include a key matrix composed of a plurality of keys.

Fig. 4 illustrates a schematic plane view of a structure of an SMT demo key according to an embodiment of the present invention. Fig. 5 illustrates a schematic side view of a structure of an SMT demo key according to an embodiment of the present invention.

As illustrated in Figs. 4 and 5, an SMT demo key 400 according to an embodiment of the present invention includes SMT pads 411, 412, 413, 414, a dome 415 and a key gold finger 420.

Being different from the conventional SMT demo key 300 illustrated in Fig. 3, the key gold finger 420 is only composed of one portion. As compared with the conventional key gold finger 320 illustrated in Fig. 3, the key gold finger 420 is appropriately smaller, which is beneficial to reduce the side effect of the capacitance performance, so as not to influence the capacitance effect between the SMT pads 413, 414, the dome 415 and the finger as much as possible. This is beneficial to improve the sensitivity of capacitance detection, and then improve the sensitivity of key touch detection.

In addition, as compared with the conventional SMT demo key 300 illustrated in Fig. 3, in the SMT demo key 400 illustrated in Fig. 4, the connection relations between the SMT pads 411, 412, 413, 414 are also changed.

As illustrated in Fig. 3, in the conventional SMT demo key 300, the SMT pads 311, 312 are electrically connected to the KEY_IN 321 of the key gold finger 320, the SMT pads 313, 314 are electrically connected to the KEY_OUT 322 of the key gold finger 320, and the SMT pads 311, 312, 313, 314 are electrically connected to corresponding terminals of the keypad scan circuit, respectively. But in the SMT demo key 400 according to the embodiment of the present invention as illustrated in Figs. 4 and 5, only the SMT pad 411 is electrically connected to the key gold finger 420 (KEY_IN). The SMT pad 412 may be reserved, for example used for KEY_IN or other particular design upon actual condition, which provides design flexibility.

The SMT pads 413, 414 are used for KEY_OUT, i.e., being electrically connected to the KEY_OUT terminal of the keypad scan circuit, and serving as a capacitive touch pad.

The key scanning operation of the SMT demo key 400 according to the embodiment of the present invention is similar to that of the conventional SMT demo key 300 illustrated in Fig. 3, and the description thereof is omitted herein. Next, the touch detection function of the SMT demo key 400 will be described in further detail.

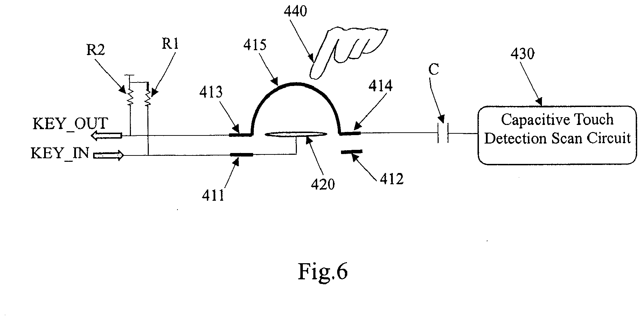

The touch detection function of the SMT demo key 400 according to the embodiment of the present invention will be described as follows with reference to the schematic circuit connection view illustrated in Fig. 6.

Referring to Fig. 6, the key gold finger 420 is electrically connected to the SMT pad 411 and used as KEY_IN, i.e., electrically connected to the KEY_IN terminal of the keypad scan circuit. The SMT pad 412 may be reserved. The dome 415 is electrically connected to the SMT pad 413 and used as KEY_OUT, i.e., electrically connected to the KEY_OUT terminal of the keypad scan circuit. In addition, the dome 415 is electrically connected to the SMT pad 414, and the SMT pad 414 is electrically connected to a capacitive touch detection scan circuit 430 provided on the circuit board of the electronic apparatus. Further, pull-up resistors R1, R2 electrically connected to the SMT pads 411, 413, respectively, are provided to enhance the drive capability of the keypad matrix.

The capacitive touch detection scan circuit 430 may be configured to detect the capacitance change caused when a finger 440 touches the key, and form a signal indicating position and/or movement by combining the position of the key.

Since the keys in the keypad matrix have the same key structure, i.e., the dome 415, the SMT pads 411-414 and the key gold finger 420 in each key have the same or substantially the same shapes and sizes and these components have the same or substantially the same arrangement relations, the capacitances formed between the dome 415, the SMT pads 413, 414 and the key gold finger 420 in each key are the same or substantially the same when there is no touch by the finger 440. When the finger 440 touches the key, the inductive capacitance of the human body overlaps the inherent capacitance of the key, thus a capacitance detected by the capacitive touch detection scan circuit 430 is obviously changed (increased) as compared with the inherent capacitance of the key.

As an example, the capacitive touch detection scan circuit 430 may be configured to compare a capacitance detected thereby with an inherent capacitance threshold TH1, and determines that corresponding key is touched by the finger 440 when a difference between the detected capacitance and the inherent capacitance threshold TH1 exceeds a predetermined capacitance change threshold TH2. Meanwhile, the capacitive touch detection scan circuit 430 can also determine which key is touched, i.e., the touch position, according to the connection relation between the keys and the capacitive touch detection scan circuit 430.

The inherent capacitance threshold TH1 is set according to the inherent capacitance of the key. For example, the inherent capacitance threshold TH1 may be predetermined by the manufacturer before the electronic apparatus leaves the factory. Alternatively, in consideration of the capacitance change that may be caused during the long term usage of the keypad, the capacitive touch detection scan circuit 430 can be operated through the software in the electronic apparatus, so that the capacitive touch detection scan circuit 430 detects a capacitance of any key when no finger touching, and sets the detected capacitance as the inherent capacitance threshold TH1. Alternatively, the capacitive touch detection scan circuit 430 can be operated through the software in the electronic apparatus, so that the capacitive touch detection scan circuit 430 detects capacitances of a plurality of keys when no finger touching, and sets an average of the detected capacitances as the inherent capacitance threshold TH1, which can reduce the influence caused by the physical structure deviation of the key advantageously.

Setting of capacitance change threshold TH2 takes into account the difference of the capacitance changes caused when different persons' different fingers touching the key. For example, the capacitance change threshold TH2 may be predetermined by the manufacturer before the electronic apparatus leaves the factory. Alternatively, the capacitive touch detection scan circuit 430 can be operated through the software in the electronic apparatus, so that the capacitive touch detection scan circuit 430 detects a capacitance of any key touched by any finger, then calculates a difference between the detected capacitance and the predetermined inherent capacitance threshold TH1, multiplies the difference with a factor ranging from 0 to 1, and provides the product as the capacitance change threshold TH2 to the capacitive touch detection scan circuit 430. The value of the factor is preferably between for example 0.1 and 0.8, more preferably between for example 0.2 and 0.6, and even more preferably between for example 0.3 and 0.5, so as to sufficiently fit the capacitance changes caused by different persons' different fingers. Alternatively, the same key or different keys may be touched by multiple fingers, then an average of the detected capacitances is calculated, a difference between the average and the predetermined inherent capacitance threshold TH1 is calculated, the difference is multiplied by the above factor, and the product is provided as the capacitance change threshold TH2 to the capacitive touch detection scan circuit 430, which beneficially reduces the influence caused by the physical structure deviation of the key and the capacitance characteristics of different persons' different fingers.

Preferably, the SMT pad 414 is connected to the capacitive touch detection scan circuit 430 through a blocking capacitor C, so that the mechanical key pressing function and the touch detection function are independent from each other. Thus, when the dome 415 is pressed to make the KEY_IN directly grounded, the capacitive touch detection scan circuit 430 will not be directly grounded to cause system confusion, thus the influence by the key operation on the touch detection can be avoided. The capacitance of the blocking capacitor C may be properly adjusted based on the specific design of the mobile phone. Preferably, the blocking capacitor C for example may have a capacitance of 1 pF.

Therefore, such key is constituted that the mechanical key pressing function and the touch detection function are combined in hardware while their operations are independent from each other. On one hand, the user's key operation may be detected as usual. On the other hand, the touch operation on the key by the user's finger may be detected.

The function of the capacitive touch detection scan circuit 430 may be enabled and/or disabled through for example software setting or operation of independently provided button.

As mentioned previously, a plurality of SMT dome keys 400 are arranged in an array as usual to form the required keypad matrix. In that case, each of the keys 400 may be connected to the capacitive touch detection scan circuit 430 through the blocking capacitor C. When the finger touches the keys on a keypad matrix while sliding thereon, the capacitive touch detection scan circuit 430 may detect the key of which the capacitance changes, so as to form a signal indicating position and/or movement of the finger by combining the position of the key, and provide this signal to a processing means to form a signal indicating position and/or movement of a cursor on the display screen.

In addition, although not illustrated in the drawings, it shall be appreciated that like the conventional key, the SMT dome key 400 according to the embodiment of the present invention may also include a non-metal key shell provided on the dome 415. The non-metal key shell may serve as the dielectric of the capacitor between the finger and the metal material portion of the key 400, so as to enhance the inductive capacitance effect.

The SMT dome key 400 with such structure may detect both a key pressing operation when the dome 415 is pressed and a capacitance change caused when the finger touches the dome 415, and can form a signal indicating position of a cursor on the display screen of the electronic apparatus by using the capacitance change and combining a position of the key. Thus the space of the electronic apparatus is saved, and the user's operation is convenient, which greatly improves the usage convenience.

An electronic apparatus is further provided according to another embodiment of the present invention, including keys with touch detection function, a circuit board, and a capacitive touch detection scan circuit. The key with touch detection function includes: a dome; a key gold finger provided on the circuit board and below the dome; and a plurality of SMT pads provided on the circuit board and around the key gold finger; wherein the dome is connected to at least two of the plurality of SMT pads, and the key gold finger is connected to one of the plurality of SMT pads, and wherein the dome is connected to the capacitive touch detection scan circuit. The capacitive touch detection scan circuit is configured to detect a capacitance change caused by a finger's touch on the key, so as to form a signal indicating touch position and/or movement of the finger by combining a position of the key.

In the above electronic apparatus, the dome may be connected to the capacitive touch detection scan circuit through a blocking capacitor. Thus, the mechanical key pressing function and the touch detection function may be separated from each other, so as to prevent the influence by the key pressing operation on the touch detection function. Preferably, the blocking capacitor C for example may have a capacitance of 1 pF.

For example, the function of the capacitive touch detection scan circuit may be enabled and/or disabled through software setting or button operation.

There may be a plurality of dome keys to form a keypad matrix.

In the above electronic apparatus, the key gold finger of each key is formed by a single metal material portion.

In the above electronic apparatus, the capacitive touch detection scan circuit is configured to determine whether a key is pressed by a finger by comparing the detected key capacitance with a predetermined threshold. For example, the predetermined threshold is set based on a capacitance when the key is not touched by the finger.

The above electronic apparatus may be various portable apparatuses such as the mobile phone.

The keys with touch detection function and the electronic apparatus including the keys according to the present invention can detect both a key pressing operation when the key is pressed and a capacitance change caused when the finger touches the key, and can form a signal indicating position of a cursor on the display screen of the electronic apparatus by using the capacitance change and combining a position of the key. Thus the space of the electronic apparatus is saved, and the user's operation is convenient, which greatly improves the usage convenience.

The preferred embodiments of the present invention are described as above with reference to the drawings. Many features and advantages of these embodiments are clear based on the detailed Description, thus it is intended that the appended claims cover all such features and advantages of these embodiments falling within the true spirit and scope of the present invention. In addition, since a person skilled in the art will easily conceive of many modifications and changes, the embodiments of the present invention are not limited to the illustrated and described accurate structures or operations, but cover all appropriate modifications and their equivalents falling within the scope.

## Claims

1. A key with touch detection function for an electronic apparatus, comprising:
a dome;
a contact points member provided on a circuit board of the electronic apparatus and below the dome;
a plurality of SMT pads provided on the circuit board of the electronic apparatus and at locations about the contact points member;
wherein the dome is connected to at least two of the plurality of SMT pads, and the contact points member is connected to one of the plurality of SMT pads,
and wherein, the dome is connected to a capacitive touch detection scan circuit provided on the circuit board of the electronic apparatus, the capacitive touch detection scan circuit is configured to detect a capacitance change caused by a finger's touch on the key, so as to form a signal indicating touch position and/or movement of the finger by combining a position of the key.

2. The key with touch detection function for an electronic apparatus of claim 1,
wherein the dome is electrically conductive and is connected to the capacitive touch detection scan circuit through a blocking capacitor.

3. The key with touch detection function for an electronic apparatus of claim 2,
wherein the blocking capacitor has a capacitance of 1 pF.

4. The key with touch detection function for an electronic apparatus of any one of claims 1-3, wherein there are a plurality of domes, and the number of the contact points members is the same as that of the domes, thereby a keypad matrix having a plurality of keys is formed.

5. The key with touch detection function for an electronic apparatus of any one of claims 1-4, wherein the contact points member is formed by a single metal material portion.

6. An electronic apparatus, comprising keys with touch detection function, a circuit board, and a capacitive touch detection scan circuit,
the key with touch detection function comprises:
a dome;
a contact points member provided on the circuit board and below the dome;
a plurality of SMT pads provided on the circuit board and about the contact points member;
wherein the dome is connected to at least two of the plurality of SMT pads, and the contact points member is connected to one of the plurality of SMT pads,
wherein the dome is connected to the capacitive touch detection scan circuit, and
the capacitive touch detection scan circuit is configured to detect a capacitance change caused by a finger's touch on the key, so as to form a signal indicating touch position and/or movement of the finger by combining a position of the key.

7. The electronic apparatus of claim 6, wherein the dome is connected to the capacitive touch detection scan circuit through a blocking capacitor.

8. The electronic apparatus of claim 7, wherein the blocking capacitor has a capacitance of 1 pF.

9. The electronic apparatus of any one of claims 6-8, wherein the function of the capacitive touch detection scan circuit is enabled and/or disabled through software setting or button operation.

10. The electronic apparatus of any one of claims 6-9, wherein there are a plurality of domes, and the number of the contact points member is the same as that of the domes, thereby a keypad matrix having a plurality of keys is formed.

11. The electronic apparatus of any one of claims 6-10, wherein the contact points member is formed by a single metal material portion.

12. The electronic apparatus of any one of claims 6-11, wherein the capacitive touch detection scan circuit is configured to determine whether the key is touched by the finger by comparing the detected key capacitance with a predetermined threshold.

13. The electronic apparatus of claim 12, wherein the predetermined threshold is set based on a capacitance when the key is not touched by the finger.

14. The electronic apparatus of any one of claims 6-13, wherein the electronic apparatus is a portable electronic apparatus.

15. The electronic apparatus of any one of claims 6-14, wherein the contact points member is a key gold finger.
